# EUROPEAN PATENT SPECIFICATION

(11) **EP 4 542 245 B1**
(45) Date of publication and mention of the grant of the patent: **11.11.2026**
(21) Application number: 22948107.2
(22) Date of filing: 24.11.2022
(51) Int. Cl.: G01R 31/52, G01R 31/54, G01R 31/389, G01R 31/392, G01R 31/396

(54) **BATTERY FAULT DIAGNOSIS METHOD AND SERVER FOR PROVIDING SAME METHOD**
BATTERIEFEHLERDIAGNOSEVERFAHREN UND SERVER ZUR BEREITSTELLUNG DES VERFAHRENS
PROCÉDÉ DE DIAGNOSTIC DE DÉFAUT DE BATTERIE ET SERVEUR POUR LA FOURNITURE DUDIT PROCÉDÉ

(30) Priority: 24.06.2022 KR 20220077533
(43) Date of publication of application: 23.04.2025
(73) Proprietor: LG Energy Solution, Ltd., Seoul 07335 (KR)
(72) Inventor: YANG, Jongyeol, Daejeon 34122 (KR); KIM, Dong Hyun, Daejeon 34122 (KR)
(74) Representative: Plasseraud IP
(86) International application number: PCT/KR2022/018749
(87) International publication number: WO 2023/249174

(56) References cited:
- EP-A1- 3 926 353
- EP-A1- 3 968 435
- JP-A- 2008 256 673
- JP-A- 2015 031 674
- JP-B2- 5 824 426
- KR-A- 20210 040 721
- KR-A- 20210 054 930
- KR-A- 20220 060 814
- US-A1- 2021 325 477

## Description

### [Technical Field]

### CROSS-REFERENCE TO RELATED APPLICATION

This application claims priority to and the benefit of Korean Patent Application No. 10-2022-0077533 filed in the Korean Intellectual Property Office on June 24, 2022.

The present invention provides a method of diagnosing a defect in a battery capable of precisely diagnosing a state of a battery including a plurality of battery cells that are connected in parallel, and a server for providing the method.

### [Background Art]

Large batteries mounted on electric vehicles, energy storage batteries, robots, satellites, and the like are required to have a higher capacity than small batteries mounted on portable terminals, laptop computers, and the like. A high-capacity battery may be configured by connecting a plurality of batteries in series and/or in parallel. In this case, the plurality of batteries may include a plurality of battery cells connected in parallel.

Meanwhile, when the number of battery cells included in a battery increases, defects may occur in the battery due to problems in the battery cells themselves and/or problems in connection between battery cells. For example, defects, such as disconnection and short circuit, between battery cells may occur. When a defect occurs in a battery, it is necessary to enable a system (for example, a vehicle, and an energy storage device) in which the battery is mounted to operate normally through quick diagnosis and correction of the defect.

However, when a plurality of battery cells is connected in parallel, it is not easy to directly sense a cell voltage or the like of an individual battery cell due to a structural problem in connection and the like. That is, it is difficult to diagnose defects of the entire battery by directly estimating defects of the battery cells themselves.

In addition, a technology for diagnosing a defect in a battery by estimating Direct Current Internal Resistance (DCIR) on a battery basis and comparing the estimated DCIR value with a preset (fixed) reference value has a limitation in not detecting a defect when a plurality of battery cells in a battery is disconnected or shorted at the same time. In addition, a problem of erroneously diagnosing the degree of change in the DC internal resistance value according to aging as occurrence of a defect.

In addition, the technology for diagnosing a defect in a battery based on the DCIR value of the battery has a problem in that, when the external temperature changes rapidly, the error range becomes too large according to the state of charge (SOC) of the battery, so that the diagnosis is not accurate.

In order to solve this problem, various studies have been conducted on methods for diagnosing defects of batteries in the related arts. However, most of the methods in the related art are simple defect diagnosis methods performed in a Battery Management System (BMS), but there is a problem in that the accuracy of diagnosis is low. A high-precision defect diagnosis method that requires a large amount of cumulative data has a limitation in that it cannot be easily implemented with a small memory capacity included in the BMS.

Example of background art can be found in document EP 3 968 435 A1.

### [Disclosure]

### [Technical Problem]

The present invention provides a method of diagnosing a defect in a battery capable of precisely diagnosing a state of a battery including a plurality of battery cells that are connected in parallel, and a server for providing the method.

The present invention provides a method of diagnosing a defect in a battery capable of accurately diagnosing a defect in a battery while overcoming a memory limitation in a Battery Management System (BMS), and a server for providing the method.

### [Technical Solution]

A server for diagnosing a defect in a battery according to one characteristic of the present invention is defined in the appended claims.

A method of diagnosing a battery is also provided.

### [Advantageous Effects]

In the present invention, the server takes the role of storing large amounts of data and complex algorithms necessary for defect diagnosis, so that the battery system has the effect of reducing the burden on the storage space and at the same time receiving high-precision defect diagnosis.

Unlike the prior art of diagnosing a defect in a battery by using a fixed reference value, the present invention diagnoses the battery defect by setting a reference value that reflects the change in the battery's internal resistance value at each diagnosis time point for diagnosing the battery defect, so that it is possible to increase the precision of diagnosis by solving the problem of erroneously diagnosing the deterioration of the battery according to the usage period of time of the battery as a defect in the battery itself.

The present invention sets a reference value based on a plurality of internal resistance values in an environment (for example, external temperature and SOC) similar to that of the current diagnosis time point for diagnosing a defect in the battery, so that it is possible to increase the precision of diagnosis by solving the problem of erroneously diagnosing the difference in external environment as a defect in the battery itself.

### [Description of the Drawings]

FIG. 1 is a diagram illustrating a battery defect diagnosis system according to an exemplary embodiment.
FIG. 2 is a block diagram illustrating a battery system 100 illustrated in FIG. 1.
FIG. 3 is a block diagram illustrating the configuration of a server 200 illustrated in FIG. 1.
FIG. 4 is a flowchart illustrating a battery defect diagnosis method according to an exemplary embodiment.
FIG. 5 is a flowchart illustrating a reference value determining operation S300 of FIG. 4 in detail.

### [Mode for Invention]

Hereinafter, an exemplary embodiment disclosed the present specification will be described in detail with reference to the accompanying drawings, and the same or similar constituent element is denoted by the same reference numeral regardless of a reference numeral, and a repeated description thereof will be omitted. Suffixes, "module" and and/or "unit" for a constituent element used for the description below are given or mixed in consideration of only easiness of the writing of the specification, and the suffix itself does not have a discriminated meaning or role. Further, in describing the exemplary embodiment disclosed in the present disclosure, when it is determined that detailed description relating to well-known functions or configurations may make the subject matter of the exemplary embodiment disclosed in the present disclosure unnecessarily ambiguous, the detailed description will be omitted.

Terms including an ordinary number, such as first and second, are used for describing various constituent elements, but the constituent elements are not limited by the terms. The terms are used only to discriminate one constituent element from another constituent element.

It should be understood that when one constituent element is referred to as being "coupled to" or "connected to" another constituent element, one constituent element can be directly coupled to or connected to the other constituent element, but intervening elements may also be present. By contrast, when one constituent element is referred to as being "directly coupled to" or "directly connected to" another constituent element, it should be understood that there are no intervening elements.

In the present application, it will be appreciated that terms "including" and "having" are intended to designate the existence of characteristics, numbers, operations, operations, constituent elements, and components described in the specification or a combination thereof, and do not exclude a possibility of the existence or addition of one or more other characteristics, numbers, operations, operations, constituent elements, and components, or a combination thereof in advance.

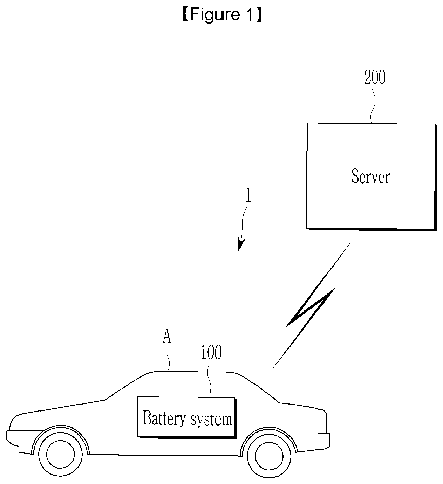

FIG. 1 is a diagram illustrating a battery defect diagnosis system according to an exemplary embodiment.

Referring to FIG. 1, a battery defect diagnosis system 1 includes a battery system 100 and a server 200.

The battery system 100 may be a system for supplying power stored in a battery to an external device. In FIG. 1, it is illustrated that the battery system 100 is mounted on the vehicle system A and supplies power to the vehicle, but is not limited thereto. The battery system 100 may be mounted anywhere as long as the battery power is required. For example, the battery system 100 may be installed in various systems, such as an Energy Storage System (ESS), a robot, a rocket, and an airplane, and supply power to a mounted upper system.

The server 200 may receive battery data from the battery system 100 at a predetermined period or in real time. In this case, the battery data may include at least one data of a battery voltage, which is a voltage of both ends of the battery, a battery current, which is a current flowing through the battery, and battery temperature, which is the temperature of the battery.

According to an exemplary embodiment, the server 200 may set a reference value based on the battery data received from the battery system 100 at each diagnosis time point for diagnosing a defect in the battery, and diagnose the defect in the battery based on the set reference value. When it is diagnosed that the defect occurred in the battery, the server 200 may transmit a warning message corresponding to the defect diagnosis to the battery system 100.

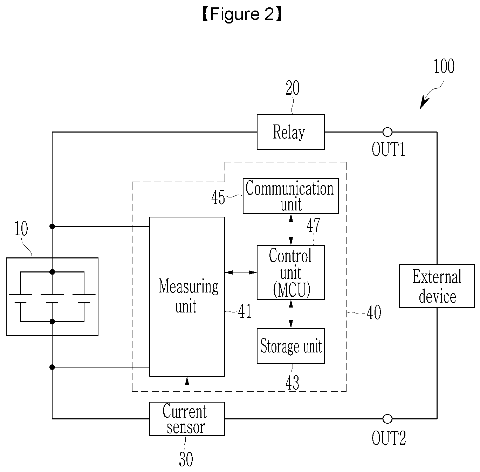

FIG. 2 is a block diagram illustrating the battery system 100 illustrated in FIG. 1.

Referring to FIG. 2, the battery system 100 includes a battery 10, a relay 20, a current sensor 30, and a Battery Management System (BMS) 40.

The battery 10 may include a plurality of battery cells connected in series and/or in parallel. In FIG. 2, three battery cells connected in parallel are illustrated, but the present invention is not limited thereto, and the battery 10 may include various numbers of battery cells connected in series and/or in parallel. In some exemplary embodiments, the battery cell may be a rechargeable secondary battery.

For example, in the battery 10, a predetermined number of battery cells is connected in parallel to form a battery bank, and a predetermined number of battery banks is connected in series to form a battery pack to supply desired power to an external device. For another example, in the battery 10, a predetermined number of battery cells is connected in parallel to form a battery bank, and a predetermined number of battery banks is connected in parallel to form a battery pack to supply desired power to an external device. However, the present invention is not limited to this connection, and the battery 10 may include a plurality of battery banks including a plurality of battery cells connected in series and/or parallel, and the plurality of battery banks may also be connected in series and/or parallel.

In FIG. 2, the battery 10 is connected between the two output terminals OUT1 and OUT2 of the battery system 100. In addition, the relay 20 is connected between a positive electrode of the battery 10 and the first output terminal OUT1, and the current sensor 30 is connected between a negative electrode of the battery -10 and the second output terminal OUT2. The configurations illustrated in FIG. 2 and the connection relationship between the configurations are examples, but the invention is not limited thereto.

The relay 20 controls electrical connection between the battery system 100 and an external device. When the relay 20 is turned on, the battery system 100 and the external device are electrically connected to perform charging or discharging, and when the relay 20 is turned off, the battery system 100 and the external device are electrically separated. In this case, the external device may be a charger in a charging cycle in which power is supplied to the battery 10 for charging, and may be a load in a discharging cycle in which the battery 10 discharges power to the external device.

The current sensor 30 is connected in series to a current path between the battery 10 and an external device. The current sensor 30 may measure the battery current flowing through the battery 10, that is, a charging current and a discharging current, and transmit the measurement result to the BMS 40.

The BMS 40 includes a measuring unit 41, a storage unit 43, a communication unit 45, and a control unit 47.

The measuring unit 41 may measure a battery voltage, which is the voltage at both ends of the battery, a battery temperature, a battery current, which is the current flowing through the battery, and the like. The battery voltage and the battery current may be battery data required to calculate internal resistance or State Of Charge (SOC) of the battery. The battery temperature may be battery data required to determine an environmental section to be described below. For example, the internal resistance may include Direct Current Internal Resistance (DCIR).

The measuring unit 41 may include a voltage sensor (not illustrated) electrically connected to both ends of the battery to measure the battery voltage, a current sensor (not illustrated) connected in series to the battery to measure the battery current, and a temperature sensor (not illustrated) for measuring the battery temperature at a location adjacent to the battery. For example, the measuring unit 41 may measure a battery voltage, a battery current, and a battery temperature at each diagnosis time point for diagnosing a defect in the battery, and transmit the measurement result to the control unit 47.

The storage unit 43 may store a battery voltage value, a battery current value, and a battery temperature value measured by the measuring unit 41.

The communication unit 45 may include a wireless communication module for communicating with the server 200 through a network. Also, the communication unit 45 may include a CAN communication module or a daisy communication module for communicating with the vehicle system A.

The communication unit 45 may transmit battery data to the server 200 under the control of the control unit 47 at each diagnosis time point for diagnosing a defect in the battery 10. In this case, the battery data may include at least one data of the battery voltage, the battery current, and the battery temperature.

The control unit 47 generally controls the BMS 40. According to an exemplary embodiment, the control unit 47 may transmit necessary battery data to the server 200 according to a command of the server 200. For example, when the communication unit 45 receives a warning message corresponding to the defect diagnosis of the battery 10 from the server 200, the control unit 47 sends an alarm message and the like corresponding to the warning message to the vehicle system A through the communication unit 45.

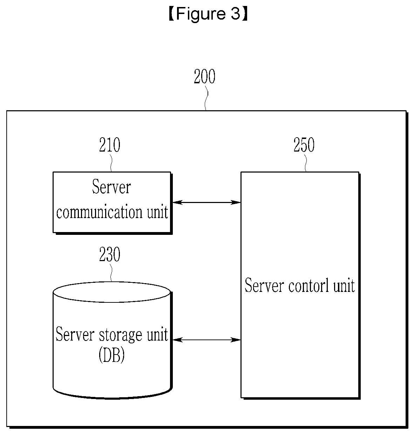

FIG. 3 is a block diagram illustrating the configuration of the server 200 illustrated in FIG. 1.

Referring to FIG. 3, the server 200 includes a server communication unit 210, a server storage unit 230, and a server control unit 250.

The server communication unit 210 may include a wireless communication module for communicating with the BMS 40 through a network.

The server communication unit 210 receives battery data from the BMS 40 at each diagnosis time point for diagnosing a defect in the battery 10. The battery data includes at least one of a battery voltage value, a battery current value, and a battery temperature value.

The server storage unit 230 stores an internal resistance value calculated by the server control unit 250 based on the battery data at each diagnosis time point for diagnosing a defect in the battery. The server storage unit 230 may store a State Of Charge (SOC) estimated by the server control unit 250 based on the battery data. Also, the server storage unit 230 may store the battery data received from the BMS 40.

According to the exemplary embodiment, for the battery defect diagnosis to be described below, the server storage unit 230 may accumulate and store an internal resistance value calculated for each diagnosis period, an estimated SOC, and measured battery data. For example, the server storage unit 230 may be installed inside the server 200, but is not limited thereto, and may be configured as a database (DB) installed in a separate external space.

When a diagnosis time point N according to a preset condition arrives, the server control unit 250 calculates a moving average MA, an upper band threshold UB_Th which is larger than the moving average by a predetermined value, a lower band threshold LB_Th which is smaller than the moving average by a predetermined value, and an internal resistance value corresponding to the diagnosis time point N.

Depending on the exemplary embodiment, a time point at which charging of the battery starts or a time point at which discharging of the battery ends may be a diagnosis time point N for diagnosing a defect in the battery. For example, when the diagnosis time point N arrives, the BMS 40 may transmit the battery data to the server 200 along with a message notifying the arrival of the diagnosis time point N. However, the present invention is not limited thereto, and in various ways, the server control unit 250 may determine whether the diagnosis time point N has arrived.

The server control unit 250 extracts a plurality of previous diagnosis time points corresponding to a predetermined number of samples based on the current diagnosis time point N, and calculates a moving average that is an average of a plurality of internal resistance values corresponding to the plurality of extracted diagnosis time points, respectively. In addition, the server control unit 250 determines an upper band threshold that is larger than the moving average by a predetermined value and a lower band threshold that is smaller than the moving average by a predetermined value. The server control unit 250 diagnoses a defect in the battery 10 by comparing the internal resistance value corresponding to the current diagnosis time point N with the upper band threshold and the lower band threshold.

According to another exemplary embodiment, the server control unit 250 may determine a sample group by extracting a plurality of diagnosis time points satisfying a first condition in which environmental data belongs to an environmental section to which environmental data of the current diagnosis time point N among the plurality of environmental sections belongs and a second condition in which the number of diagnosis time points corresponds to the predetermined number SN of samples when a diagnosis time point is counted in the direction of the previous diagnosis time point based on the current diagnosis time point N.. In this case, the number SN of samples is the number of a plurality of diagnosis time points included in the sample group, and may be determined as an optimal number based on an experiment or the like. The sample group is a subgroup of a plurality of past diagnosis time points, which is a population, and may be a group for calculating a moving average MA and an standard deviation average value σ_ave, which will be described below.

Hereinafter, Table 1 is an example of a look-up table for storing the battery temperature, the SOC, the internal resistance (DCIR) value, the moving average MA, the upper band threshold UB_Th, and the lower band threshold LB_Th measured, estimated, and calculated at each of a plurality of diagnosis time points. The look-up table may be stored in the server storage unit 230.

Hereinafter, it is assumed that the number SN of samples is 5, a plurality of temperature sections (for example, 0°C to 20°C, 21°C to 40°C, 41°C to 60°C,...) distinguished by a predetermined temperature size interval (for example, 20°C interval) is set, and a plurality of charge intervals (for example, 11% to 30%, 31% to 50%, 51% to 70%, 71% to 90%) distinguished by a predetermined SOC size interval (for example, 20% interval) is set.

According to the exemplary embodiment, in Table 1 below, it is assumed that the environmental data includes at least one of a battery temperature and an SOC. In this case, the environmental data may be a factor affecting the internal resistance value of the battery 10. For example, when it is assumed that all other conditions are the same but the battery temperature is different, the internal resistance value of the battery 10 may be different. For another example, when it is assumed that all other conditions are the same but the SOCs are different, the internal resistance values of the batteries 10 may be different.

For reference, in Table 1 below, it may be difficult to directly calculate the moving average MA, the standard deviation σ, the standard deviation average value σ_ave, the upper band threshold UB_Th, and the lower band threshold LB_Th of the first diagnosis time point 1. (therefore, the corresponding values in Table 1 are marked with blanks). In addition, it may also be difficult to directly calculate the moving averages MA, the standard deviations σ, the standard deviation average values σ_ave, the upper band thresholds UB_Th, and the lower band thresholds LB_Th at diagnosis time points 2, 3,... adjacent to the first diagnosis time point 1 because there are no or insufficient past diagnostic values for calculation. In this case, the values calculated on average according to the experiment may be replaced with the moving averages MA, the standard deviations σ, the standard deviation average values σ_ave, the upper band thresholds UB_Th, and the lower band thresholds LB_Th at the initial diagnosis time points 1, 2, 3, ..... In addition, example values for an internal resistance value, a moving average, and the like in the N-8^{th} diagnostic period, which are not used in the following description, are omitted.

**(Table 1)**

| **Diagnosis Period** | | **1** | **...** | **N-8** | **N-7** | **N-6** | **N-5** | **N-4** | **N-3** | **N-2** | **N-1** | **N** |
|---|---|---|---|---|---|---|---|---|---|---|---|---|
| **Environ ment** | **Tempe rature** | | **...** | **25** | **24** | **23** | **22** | **8** | **20** | **23** | **23** | **25** |
| | **SOC** | | **...** | **50** | **53** | **11** | **55** | **60** | **50** | **55** | **55** | **60** |
| **Internal Resistance(DCIR)** | | | **...** | **15** | **25** | **27** | **23** | **24** | **20** | **21** | **23** | **①** |
| **Moving Average (MA)** | | | **...** | | **22.5** | **21** | **22** | **23.5** | **23** | **22** | **24** | **②** |
| **standard deviations(a)** | | | **...** | | **1.56** | **1.60** | **1.70** | **1.60** | **1.82** | **1.73** | **1.63** | **③** |
| **standard deviation average value (σ_ave)** | | | **...** | | **1.55** | **1.62** | **1.65** | **1.62** | **1.70** | **1.65** | **1.55** | **④** |
| **Upper Band threshold (UB_Th)** | | | **...** | | **27.15** | **26.20** | **26.95** | **27.90** | **28.1** | **26.95** | **28.65** | **⑤** |
| **Lower Band thresholds (LB_Th)** | | | **...** | | **17.85** | **15.8** | **17.05** | **19.1** | **17.9** | **17.05** | **19.35** | **⑥** |
| **Diagnosis Result** | | | | | **Normal** | **Abnormal** | **Normal** | **Normal** | **Normal** | **Normal** | **Normal** | **⑦** |

In Table 1, the temperature section to which the battery temperature (25°C) at the current diagnosis time point N belongs is 21°C to 40°C. In addition, the state of charge section to which the state of charge (60%) at the current diagnosis time point N belongs is 51% to 70%.

The server control unit 250 may extract an N-1^{th} diagnosis time point, an N-2^{th} diagnosis time point, an N-3^{th} diagnosis time point, an N-5^{th} diagnosis time point, and an N-7^{th} diagnosis time point which belong to an environment (21°C to 40°C and 51% to 70%) similar to that of the current diagnosis time point N, that is, the Nth diagnosis time point, and simultaneously corresponds to the number SN of samples of 5 when the diagnosis time point is counted in the direction of the previous diagnosis time point based on the current diagnosis time point N, and determine a sample group. In this case, at the N-4^{th} diagnosis time point, the corresponding battery temperature (8°C) belongs to a temperature section (0°C to 20°C) different from the temperature section (21°C to 40°C) to which the battery temperature (25°C) at the N^{th} diagnosis time point belongs. At the N-6^{th} diagnosis time point, the corresponding state of charge (11%) belongs to a state of charge section (11% to 30%) different from the state of charge section (51% to 70%) to which the state of charge (60%) at the N^{th} diagnosis time point belongs. The N-8^{th} diagnosis time point is in a similar environment (21°C to 40°C and 51% to 70%) as the N^{th} diagnosis time point, but the time interval from the N^{th} diagnosis time point is large, so the N-8^{th} diagnosis time point is not included in the number SN of samples. That is, the N-4^{th} diagnosis time point, the N-6^{th} diagnosis time point, and the N-8^{th} diagnosis time point are not included in the sample group.

According to another exemplary embodiment, environmental data may include a battery temperature or an SOC. For example, in Table 1 above, when it is assumed that the environmental data includes only the battery temperature, the server control unit 250 may include the N-1^{th} diagnosis time point (23°C), the N-2^{th} diagnosis time point (23°C), the N-3^{th} diagnosis time point (20°C), the N-5^{th} diagnosis time point (22°C), and the N-6^{th} diagnosis time point (23°C) belonging to a similar environment (21°C to 40° C.) to the N^{th} diagnosis time point in the sample group. As another example, in Table 1, when it is assumed that the environmental data includes only the state of charge (SOC), the server control unit 250 may include the N-1^{th} diagnosis time point (55%), the N-2^{th} diagnosis time point (55%), and the N-3^{th} diagnosis time point (50%), the N-4^{th} diagnosis time point (60%), and the N-5^{th} diagnosis time point (55%) belonging to an environment (51% to 70%) similar to the N^{th} diagnosis time point in the sample group.

In summary, the server control unit 250 may determine a sample group by extracting a plurality of diagnosis time points adjacent to the diagnosis time point N while being in an environment similar to that of the predetermined diagnosis time point N. For example, the server control unit 250 may determine a sample group by extracting a plurality of diagnosis time points N-7, N-5, N-3, N-2, and N-1 according to the criteria described above, and determine reference values (upper and lower band thresholds to be described below) used for defect diagnosis based on the internal resistance values calculated at the plurality of diagnosis time points belonging to the sample group. Then, it is possible to solve the problem of erroneously diagnosing the degree of aging due to long-term use of the battery and/or the temporary change in internal resistance value as a defect of the battery.

Next, the server control unit 250 determines the reference value (upper band threshold and lower band threshold) for diagnosing the defect of the battery the N^{th} diagnosis time point based on the internal resistance value calculated at each of the plurality of diagnosis time points N-7, N-5, N-3, N-2, and N-1 belonging to the sample group.

According to the exemplary embodiment, the server control unit 250 compares a value of the internal resistance DCIR corresponding to the N^{th} diagnosis time point with the upper band threshold UB_{N}_Th and the lower band threshold LB_Th to diagnose a defect in the battery. For example, referring to Table 1, at the N^{th} diagnosis time point, the server control unit 250 calculates the internal resistance value (①), the upper band threshold (⑤) and the lower band threshold (⑥), and compares the calculated internal resistance value (①) with the upper band threshold (⑤) and the lower band threshold (⑥) to diagnose the defect of the battery. In this case, in order to calculate the upper band threshold (⑤) and the lower band threshold (⑥), the moving average (②) and the standard deviation average value (④) are required. However, the standard deviation (③) is not a value necessary for defect diagnosis at the N^{th} diagnosis time point, but is necessary for defect diagnosis at the next diagnosis time points N+1, N+2,..., so that the standard deviation (③) may be calculated at the N^{th} diagnosis time point and stored in the server storage unit 230.

Hereinafter, the internal resistance value (①), the moving average (②), the standard deviation (③), the standard deviation average value (④), the upper band threshold (⑤), and the lower band threshold (⑥) calculated by the server control unit 250 at the N^{th} diagnosis time point in Table 1 will be described.

The server control unit 250 may calculate the internal resistance DCIR_{N} value corresponding to the N^{th} diagnosis time point based on the battery voltage, which is the voltage of the both ends of the battery 10, and the battery current, which is the current flowing through the battery 10. For example, the value of the internal resistance DCIR_{N} (①) may be calculated by Equation 1 below. $DCI {R}_{N} = \frac{Δ V}{I}$ (equation 1)

For example, the server control unit 250 may calculate a voltage difference (ΔV = |V1 - V2|) between a battery voltage V1 corresponding to a first time point when charging starts and a battery voltage V2 corresponding to a second time point after a predetermined time has elapsed from the first time point. The server control unit 250 may calculate the internal resistance DCIR_{N} value based on the charging current I flowing through the battery and the voltage difference ΔV. For example, it is assumed that the internal resistance DCIR_{N} value corresponding to the N^{th} diagnosis time point N is calculated as 30Ω.

Referring to Table 1, the server control unit 250 may calculate an moving average MA_{N} (②) corresponding to the N^{th} diagnosis time point N by averaging (25Ω+ 23Ω+ 20Ω+ 21Ω+ 23Ω/5 = 22.4) the plurality of internal resistance values (25Ω, 23Ω, 20Ω, 21Ω, 23Ω) corresponding to the plurality of diagnosis time points (N-7, N-5, N-3, N-2, N-1), respectively, belonging to the sample group. That is, the moving average MA_{N}corresponding to the N^{th} diagnosis time point N may be 22.4 Ω. Calculating for the moving average MA_{N} may be calculated by equation 2. $M {A}_{N} = \frac{DCI {R}_{N - 7} + DCI {R}_{N - 5} + DCI {R}_{N - 3} + DCI {R}_{N - 2} + DCI {R}_{N - 1}}{SN}$ (equation 2)

Referring to Table 2 below, the server control unit 250 may calculate a standard deviation *σ_{N}* (③) corresponding to the N^{th} diagnosis time point N based on the internal resistance DCIR value corresponding to each of the plurality of diagnosis time points N-7, N-5, N-3, N-2, and N-1 belonging to the sample group and the moving average MA.

**(Table 2)**

| | **N-7** | **N-5** | **N-3** | **N-2** | **N-1** | **N** |
|---|---|---|---|---|---|---|
| **Internal resistance (DCIR)** | 25 | 23 | 20 | 21 | 23 | |
| **\|DCIR** - **MA\|** | \| 25-22.4\| =2.6 | \| 23-22.4\| =0.6 | \|20-22.4\|=2.4 | \|21-22.4\| =1.4 | \|23-22.4\| =0.6 | |
| **(DCIR** - **MA)²** | (2.6)² = 6.76 | (0.6)² = 0.36 | (2.4)² =5.76 | (1.4)² =1.96 | (0.6)² = 0.36 | |
| **Variance** | (6.76+0.36 +5.76+1.96+0.36)/5 = 3.04 | | | | | |
| **Standard deviation (σ_{N})** | $\sqrt{3.04} = 1.74355957742 \left(≒1.74\right)$ | | | | | 1.74 |

As described above, the standard deviation *σ_{N}* (③) corresponding to the N^{th} diagnosis time point N is not a value necessary for defect diagnosis at the N^{th} diagnosis time point, but is necessary when defects are diagnosed at the next diagnosis time points N+1, N+2, and .... Accordingly, the standard deviation *σ_{N}* (③) corresponding to the N^{th} diagnosis time point N may be calculated at the N^{th} diagnosis time point N and stored in the server storage unit 230.

Referring to Table 3 below, the server control unit 250 calculates a standard deviation average value *σ*_{*N*_*ave*} (④) corresponding to the N^{th} diagnosis time point N based on the plurality of standard deviations σ_{N-7}, σ_{N-5}, σ_{N-3}, σ_{N-2}, and σ_{N-1} corresponding to the plurality of diagnosis time points N-7, N-5, N-3, N-2, and N-1, respectively, belonging to the sample group.

**(Table 3)**

| | **N-7** | **N-5** | **N-3** | **N-2** | **N-1** | **N** |
|---|---|---|---|---|---|---|
| **standard deviations(σ)** | 1.56 | 1.70 | 1.82 | 1.73 | 1.63 | |
| **standard deviation average value (*σ*_{*N*_}ave)** | (1.56+1.70+1.82+1.73+1.63)/5 = 1.688(≒ 1.69) | | | | | **1.69** |

The server control unit 250 calculates an upper band threshold UB_{N}_Th, which is larger than the moving average MA_{N} by a predetermined value, and a lower band threshold LB_{N}_Th, which is smaller than the moving average MA, by a predetermined value. The server control unit 250 calculates a first error value by multiplying the standard deviation average value *σ*_{*N*_*ave*} by a predetermined first multiple, and calculate the upper band threshold UB_{N}_Th by adding the first error value to the moving average MA_{N}. In addition, the server control unit 250 may calculate a second error value by multiplying the standard deviation average value *σ*_{*N*_*ave*} by a predetermined second multiple, and calculate the lower band threshold LB_{N}_Th by subtracting the second error value from the moving average MA_{N}. In this case, the first multiple and the second multiple are the same, but in embodiments not covered by the appended claims they are not limited thereto and the error value may be calculated as various multiples.

According to the exemplary embodiment, the server control unit 250 may calculate an error value (E = *σ*_{*N*_*ave*} × Q) by multiplying the standard deviation average value *σ*_{*N*_*ave*} that is the average of the standard deviations of the sample group by a predetermined multiple Q. In this case, the multiple Q is a value for reflecting a predetermined error, and may be determined by various values through experiments. For example, it is assumed that the multiple Q is the natural number 3.

The server control unit 250 may calculate the upper band threshold UB_{N}_Th of 27.47 by adding the error value (E = *σ*_{*N*_*ave*} × Q = 1.69 × 3) to the moving average (MA_{N} = 22.4) of the sample group as illustrated in Equation 3 below. In addition, the server control unit 250 may calculate the lower band threshold LB_{N}_Th of 17.33 by subtracting the error value (E= *σ*_{*N*_*ave*} × Q = 1.69 × 3) from the moving average (MA_{N} = 22.4) of the sample group as illustrated in Equation 4 below. ${UB}_{N} _ Th = {MA}_{N} + \left({σ}_{N}_ave\times Q\right)$ (equation 3) ${LB}_{N} _ Th = {MA}_{N} - \left({σ}_{N}_ave\times Q\right)$ (equation 4)

Next, the server control unit 250 may compare the value of the internal resistance DCIR_{N} corresponding to the N^{th} diagnosis time point with the upper band threshold UB_{N}_Th and the lower band threshold LB_{N}_Th corresponding to the N^{th} diagnosis time point N to diagnose a defect in the battery.

According to the exemplary embodiment, when the internal resistance DCIR_{N} value exceeds the upper band threshold UB_{N}_Th, the server control unit 250 may diagnose that a disconnection defect (DD) has occurred in at least one of a plurality of battery cells included in the battery 10. When the value of the internal resistance DCIR_{N} value is less than the lower band threshold LB_{N}_Th, the server control unit 250 may diagnose that a short defect (SD) has occurred in at least one of a plurality of battery cells included in the battery 10. That is, when the value of the internal resistance DCIR_{N} value is out of the normal range corresponding to the lower band threshold LB_{N}_Th or more and the upper band threshold UB_{N}_Th or less, the server control unit 250 may diagnose that a defect (disconnection defect or short defect) has occurred in the battery 10. In addition, when the value of the internal resistance DCIR_{N} value falls within the normal range, the server control unit 250 may diagnose the state of the battery 10 as normal.

For example, as described above through Tables 1 and 3 and Equations 1 to 4, the internal resistance DCIR_{N} value, the upper band threshold UB_{N}_Th, and the lower band threshold LB_{N}_Th corresponding to the N^{th} diagnosis time point may be calculated as 30 Ω, 27.47, and 17.33, respectively. In this case, the server control unit 250 may diagnose a battery defect (disconnection defect) based on the fact that the internal resistance value (DCIR_{N} = 30) exceeds the upper band threshold (UB_{N}_Th = 27.47).

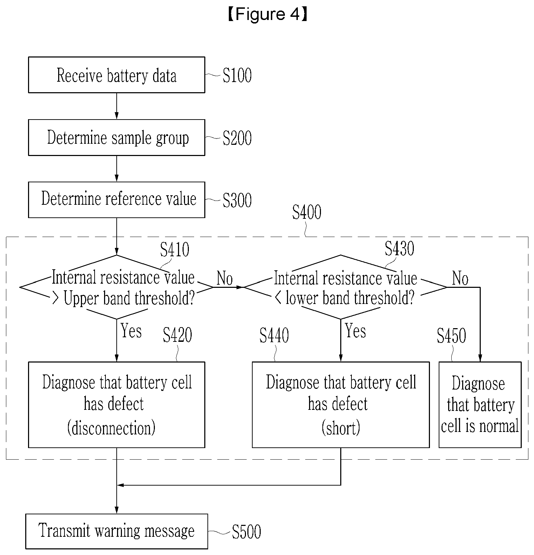

FIG. 4 is a flowchart illustrating a battery defect diagnosis method according to an exemplary embodiment.

Hereinafter, the method of diagnosing the defect in the battery and the server for providing the method will be described with reference to FIGS. 1 to 4.

First, the server control unit 250 receives battery data from the battery system 100 (S100). In this case, the battery data may include at least one of a battery voltage, which is a voltage of both ends of the battery 10, a battery temperature, and a battery current, which is a current flowing through the battery 10.

For example, the battery voltage and the battery current may be battery data required to calculate Direct Current Internal Resistance (DCIR) or an SOC of the battery. The battery temperature may be battery data required to determine an environmental section to be described below.

Next, the server control unit 250 may determine a sample group by extracting a plurality of diagnosis time points which is adjacent to a diagnosis time point N while being in an environment similar to that of the predetermined diagnosis time point N (S200).

The server control unit 250 may determine a sample group by extracting a plurality of diagnosis time points which satisfies 1) a first condition in which environmental data belongs to a predetermined environmental section to which the environmental data at the predetermined diagnosis time point N, that is, an N^{th} diagnosis time point, belongs, and 2) a second condition in which the number of diagnosis time points corresponds to the predetermined number SN of samples when the diagnosis time point is counted in a direction of a previous diagnosis time point based on the N^{th} diagnosis time point. According to the exemplary embodiment, the server control unit 250 may determine a sample group by extracting a plurality of diagnosis time points satisfying both the first condition and the second condition. According to another exemplary embodiment, the server control unit 250 may determine a sample group by extracting a plurality of diagnosis time points satisfying the second condition.

For example, it is assumed that environmental data includes both a battery temperature and a state of charge (SOC), and the number SN of samples is 5. In Table 1, the server control unit 250 may determine a sample group by extracting an N-1^{th} diagnosis time point, an N-2^{th} diagnosis time point, an N-3^{th} diagnosis time point, an N-5^{th} diagnosis time point, and an N-7^{th} diagnosis time point, which belong to the environment (21°C to 40°C and 51% to 70%) similar to that of the N^{th} diagnosis time point N and simultaneously correspond to the number SN of samples of 5 when the diagnosis time point is counted in the direction of a previous diagnosis time point based on the N^{th} diagnosis time point N.

Next, the server control unit 250 determines a reference value for the diagnosis of a defect of the battery 10 (S300). According to the exemplary embodiment, the reference value may include an upper band threshold UB_{N}_Th and a lower band threshold LB_{N}_Th.

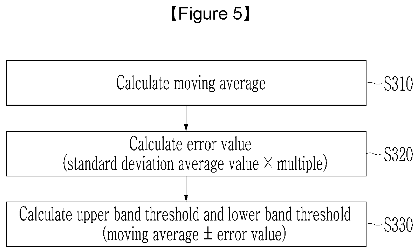

In operation S300, referring to FIG. 5, the server control unit 250 averages the plurality of internal resistance values corresponding to the plurality of diagnosis time points, respectively, belonging to the sample group to calculate a moving average MA_{N} of the sample group (S310).

Referring to Table 1 and Equation 2 above, the serer control unit 250 may calculate the moving average MA_{N} of 22.4 corresponding to the N^{th} diagnosis time point N by averaging the plurality of internal resistance values 25Ω, 23Ω, 20Ω, 21Ω, and 23Ω corresponding to the plurality of diagnosis time points N-7, N-5, N-3, N-2, and N-1, respectively, belonging to the sample group.

In operation S300, the server control unit 250 calculates an error value E based on the standard deviation average value *σ*_{*N*_*ave*} of the sample group (S320).

For example, the standard deviation average value *σ*_{*N*_*ave*} of the sample group may be calculated by averaging the plurality of standard deviations corresponding to the plurality of diagnosis time points, respectively, belonging to the sample group.

Referring to Table 1 and Table 3 above, the server control unit 250 may calculate an standard deviation average value *σ*_{*N*_*ave*} of 1.69 corresponding to the diagnosis time point N based on the plurality of standard deviations σ_{N-7}, σ_{N-5}, σ_{N-3}, σ_{N-2}, σ_{N-1} corresponding to the plurality of diagnosis time points N-7, N-5, N-3, N-2, and N-1, respectively, belonging to the sample group. In addition, the server control unit 250 may calculate an error value (E= *σ*_{*N*_*ave*} × Q = 1.69 × 3) by multiplying the standard deviation average value *σ*_{*N*_*ave*} by a predetermined multiple Q. In this case, the multiple Q is a value for reflecting a predetermined error, and may be determined by various values through experiments. For example, it is assumed that the multiple Q is the natural number 3.

In operation S300, the server control unit 250 calculates an upper band threshold UB_{N}_Th and a lower band threshold LB_{N}_Th based on the moving average MA_{N} and the error value E of the sample group (S330).

Referring to Equation 3, the server control unit 250 may calculate the upper band threshold UB_{N}_Th of 27.47 by adding the error value (E = *σ*_{*N*_*ave*} × Q = 1.69 × 3) to the moving average (MA_{N} = 22.4) of the sample group. In addition, referring to Equation 4, the server control unit 250 may calculate the lower band threshold LB_{N}_Th of 17.33 by subtracting the error value (E= *σ*_{*N*_*ave*} × Q = 1.69 × 3) from the moving average (MA_{N} = 22.4) of the sample group.

Next, the server control unit 250 may compare the value of the internal resistance DCIR_{N} corresponding to the N^{th} diagnosis time point N with the upper band threshold UB_{N}_Th and the lower band threshold LB_{N}_Th corresponding to the N^{th} diagnosis time point to diagnose a defect in the battery 10 (S400).

The server control unit 250 may calculate the internal resistance DCIR_{N} value corresponding to the N^{th} diagnosis time point N based on the battery voltage, which is the voltage of the both ends of the battery 10, and the battery current, which is the current flowing through the battery 10. In addition, the internal resistance DCIR_{N} value may be calculated in operation S200 or operation S300, and the calculation time point is not limited as long as the internal resistance DCIR_{N} value is calculated before operation S400, which is the diagnosis time point.

For example, the server control unit 250 may calculate a voltage difference (ΔV = |V1 - V2|) between a battery voltage V1 corresponding to a first time point when charging of the battery 10 starts and a battery voltage V2 corresponding to a second time point after a predetermined time has elapsed from the first time point. The server control unit 250 may calculate the internal resistance DCIR_{N} value based on the charging current I flowing through the battery 10 and the voltage difference ΔV. For example, it is assumed that the internal resistance DCIR_{N} value corresponding to the N^{th} diagnosis time point is calculated as 30Ω.

In operation S400, the server control unit 250 determines whether the value of the internal resistance DCIR_{N} exceeds the upper band threshold UB_{N}_Th (S410).

In operation S400, when the value of the internal resistance DCIR_{N} exceeds the upper band threshold UB_{N}_Th as a result of the determination (S410, YES), the server control unit 250 diagnoses that a disconnection defect has occurred in at least one of a plurality of battery cells included in the battery 10 (S420).

For example, when the parallel connection of some battery cells among a plurality of battery cells connected in parallel is disconnected, the internal resistance value of the battery 10 may increase.

In operation S400, when the value of the internal resistance DCIR_{N} does not exceed the upper band threshold UB_{N}_Th as a result of the determination (S410, NO), the server control unit 250 determines whether the internal resistance DCIR_{N} value is less than the lower band threshold LB_{N}_Th (S430).

In operation S400, when the internal resistance DCIR_{N} value is less than the lower band threshold LB_{N}_Th as a result of the determination (S430, YES), the server control unit 250 diagnoses that a short defect has occurred in at least one of a plurality of battery cells included in the battery 10 (S440).

For example, when some battery cells among a plurality of battery cells connected in parallel has short, the internal resistance value, that is the entire resistance, of the battery 10 may decrease.

In operation S400, when the internal resistance DCIR_{N} value is equal to or larger than the lower band threshold LB_{N}_Th as a result of the determination (S430, NO), the server control unit 250 diagnoses the state of the battery 10 as normal (S450).

When the value of the internal resistance DCIR_{N} is out of a normal range corresponding to the lower band threshold LB_{N}_Th or more and the upper band threshold UB_{N}_Th or less, the server control unit 250 may diagnose the state of the battery 10 as a defect (disconnection defect or short defect). In addition, when the value of the internal resistance DCIR_{N} falls within the normal range, the server control unit 250 may diagnose the state of the battery 10 as a normal state.

Next, the server control unit 250 may transmit an alarm message corresponding to the diagnosis result of the battery 10 to the BMS 40 (S500).

For example, when it is determined that the state of the battery 10 has the disconnection defect (S420) and the short defect (S440), the server control unit 250 may transmit a warning message corresponding to the defect diagnosis to the BMS 40 (S500). For another example, when it is determined that the state of the battery 10 is normal, the server control unit 250 may transmit the alarm message corresponding to the normal state to the BMS 40 (S500).

## Claims

1. A server (200) for diagnosing a defect in a battery (10), the server (200) comprising:
a server communication unit (210) for receiving battery data including at least one of a battery voltage, which is a voltage at both ends of a battery (10), a battery current, which is a current flowing through the battery (10), and a battery temperature, which is a temperature of the battery (10), from a battery management system, BMS, (40);
a server storage unit (230) for storing an internal resistance value (DCIR) of the battery (10) calculated based on the battery data at each diagnosis time point for diagnosing a defect in the battery (10); and
a server control unit (250) for extracting a plurality of previous diagnosis time points corresponding to a predetermined number of samples based on the diagnosis time point for each diagnosis time point, calculating a moving average (MA) that is an average of a plurality of internal resistance values (DCIR) corresponding to the plurality of diagnosis time points, respectively, and comparing the internal resistance value (DCIR) with an upper band threshold (UB_Th), which is larger than the moving average (MA) by a predetermined value, and a lower band threshold (LB_Th), which is smaller than the moving average (MA) by a predetermined value, to diagnose a defect in the battery (10);
**characterized in that**:
the server control unit (250)
calculates an error value (E) by multiplying a standard deviation average value, which is an average of a plurality of standard deviations corresponding to the plurality of diagnosis time points, respectively, by a predetermined multiple,
calculates the upper band threshold (UB_Th) by adding the error value (E) to the moving average (MA), and
calculates the lower band threshold (LB_Th) by subtracting the error value (E) from the moving average (MA).

2. The server of claim 1, wherein:
when the internal resistance value (DCIR) exceeds the upper band threshold (UB_Th),
the server control unit (250) diagnoses that a disconnection defect has occurred in at least one of a plurality of battery cells included in the battery (10).

3. The server of claim 1, wherein:
when the internal resistance value (DCIR) is less than the lower band threshold (LB_Th),
the server control unit (250) diagnoses that a short defect has occurred in at least one of a plurality of battery cells included in the battery (10).

4. The server of claim 1, wherein:
the server storage unit (230)
further stores environmental data including at least one of a State of Charge (SOC) estimated by a predetermined method and the measured battery temperature, and
the server control unit (250)
extracts the plurality of diagnosis time points based on a first condition including environmental data corresponding to environmental data at the diagnosis time point within a predetermined range and a second condition, which is a previous diagnosis time point corresponding to the number of samples based on the diagnosis time point.

5. The server of claim 4, wherein:
the first condition
is a condition in which a battery temperature at a predetermined diagnosis time point belongs to a predetermined temperature section to which the battery temperature corresponding to the diagnosis time point belongs among a plurality of temperature sections set at predetermined temperature size intervals.

6. The server of claim 4, wherein:
the first condition
is a condition in which an SOC at a predetermined diagnosis time point belongs to a predetermined SOC section to which the SOC corresponding to the diagnosis time point belongs among a plurality of SOC sections set at predetermined SOC size intervals.

7. A method of diagnosing a battery, the method comprising:
a data receiving operation (S100) for receiving, by a server, battery data including at least one of a battery voltage, which is a voltage at both ends of a battery (10), a battery current, which is a current flowing through the battery (10), and a battery temperature, which is a temperature of the battery (10), from a battery management system, BMS, (40);
a sample group determining operation (S200) for extracting, at a diagnosis time point for diagnosing a defect of the battery (10), a plurality of previous diagnosis time points corresponding to the predetermined number of samples based on the diagnosis time point;
a reference value determining operation (S300) of calculating a moving average (MA), which is an average of a plurality of internal resistance values (DCIR) corresponding to the plurality of diagnosis time points, respectively, an upper band threshold (UB_Th), larger than the moving average (MA) by a predetermined value, and a lower band threshold (LB_Th), smaller than the moving average (MA) by a predetermined value; and
a defect diagnosis operation (S400) of diagnosing a defect in the battery by comparing the internal resistance value (DCIT) corresponding to the diagnosis time point with the upper band threshold (UB_Th) and the lower band threshold (LB_Th);
**characterized in that**:
the reference value determining operation (S300) includes
calculating (S320) an error value (E) by multiplying a standard deviation average value, which is an average of a plurality of standard deviations corresponding to the plurality of diagnosis time points, respectively, by a predetermined multiple,
calculating (S330) the upper band threshold (UB_Th) by adding the error value (E) to the moving average (MA), and
calculating (S330) the lower band threshold (LB_Th) by subtracting the error value (E) from the moving average (MA).

8. The method of claim 7, wherein:
in the defect diagnosis operation (S400),
when the internal resistance value (DCIR) corresponding to the diagnosis time point exceeds the upper band threshold (UB_Th),
it is diagnosed that a disconnection defect has occurred in at least one of a plurality of battery cells included in the battery (10).

9. The method of claim 7, wherein:
in the defect diagnosis operation (S400),
when the internal resistance value (DCIR) corresponding to the diagnosis time point is less than the lower band threshold (LB_Th),
it is diagnosed that a short defect has occurred in at least one of a plurality of battery cells included in the battery (10).

10. The method of claim 7, wherein:
the sample group determining operation (S200) includes
extracting the plurality of diagnosis time points based on a first condition including environmental data corresponding to environmental data at the diagnosis time point within a predetermined range and a second condition, which is a previous diagnosis time point corresponding to the number of samples based on the diagnosis time point, and
the environmental data includes
at least one of a State of Charge (SOC) estimated by a predetermined method and the measured battery temperature.

11. The method of claim 10, wherein:
the first condition
is a condition in which a battery temperature at a predetermined diagnosis time point belongs to a predetermined temperature section to which the battery temperature corresponding to the diagnosis time point belongs among a plurality of temperature sections set at predetermined temperature size intervals.

12. The method of claim 10, wherein:
the first condition
is a condition in which an SOC at a predetermined diagnosis time point belongs to a predetermined SOC section to which the SOC corresponding to the diagnosis time point belongs among a plurality of SOC sections set at predetermined SOC size intervals.

## Patentansprüche

1. Server (200) zur Diagnose eines Fehlers in einer Batterie (10), wobei der Server (200) Folgendes umfasst:
• eine Server-Kommunikationseinheit (210) zum Empfangen von Batteriedaten, die mindestens eines aus einer Batteriespannung, bei der es sich um eine Spannung an beiden Enden einer Batterie (10) handelt, einem Batteriestrom, bei dem es sich um einen durch die Batterie (10) fließenden Strom handelt, und einer Batterietemperatur, bei der es sich um eine Temperatur der Batterie (10) handelt, umfassen, von einem Batteriemanagementsystem, BMS, (40);
• eine Server-Speichereinheit (230) zum Speichern eines internen Widerstandswerts (DCIR) der Batterie (10), der basierend auf den Batteriedaten zu jedem Diagnosezeitpunkt zur Diagnose eines Fehlers in der Batterie (10) berechnet wird; und
• eine Server-Steuereinheit (250) zum Extrahieren einer Vielzahl von vorherigen Diagnosezeitpunkten, die einer vorbestimmten Anzahl von Proben basierend auf dem Diagnosezeitpunkt für jeden Diagnosezeitpunkt entsprechen, Berechnen eines gleitenden Mittelwerts (MA), der ein Mittelwert einer Vielzahl von internen Widerstandswerten (DCIR) ist, die jeweils der Vielzahl von Diagnosezeitpunkten entsprechen, und Vergleichen des internen Widerstandswerts (DCIR) mit einem oberen Bandschwellenwert (UB_Th), der um einen vorbestimmten Wert größer als der gleitende Mittelwert (MA) ist, und einem unteren Bandschwellenwert (LB_Th), der um einen vorbestimmten Wert kleiner als der gleitende Mittelwert (MA) ist, um einen Fehler in der Batterie (10) zu diagnostizieren;
**dadurch gekennzeichnet, dass**:
die Server-Steuereinheit (250)
• einen Fehlerwert (E) durch Multiplizieren eines Standardabweichungsmittelwerts, der ein Mittelwert einer Vielzahl von Standardabweichungen ist, die jeweils der Vielzahl von Diagnosezeitpunkten entsprechen, mit einem vorbestimmten Vielfachen berechnet,
• den oberen Bandschwellenwert (UB_Th) durch Addieren des Fehlerwerts (E) zum gleitenden Mittelwert (MA) berechnet, und
• den unteren Bandschwellenwert (LB_Th) durch Subtrahieren des Fehlerwerts (E) vom gleitenden Mittelwert (MA) berechnet.

2. Server nach Anspruch 1, wobei:
wenn der interne Widerstandswert (DCIR) den oberen Bandschwellenwert (UB_Th) überschreitet,
die Server-Steuereinheit (250) diagnostiziert, dass ein Trennungsfehler in mindestens einem einer Vielzahl von in der Batterie (10) enthaltenen Batteriezellen aufgetreten ist.

3. Server nach Anspruch 1, wobei:
wenn der interne Widerstandswert (DCIR) kleiner als der untere Bandschwellenwert (LB_Th) ist,
die Server-Steuereinheit (250) diagnostiziert, dass ein Kurzschlussfehler in mindestens einem einer Vielzahl von in der Batterie (10) enthaltenen Batteriezellen aufgetreten ist.

4. Server nach Anspruch 1, wobei:
die Server-Speichereinheit (230)
• ferner Umweltdaten speichert, die mindestens eines aus einem Ladezustand (SOC), der durch ein vorbestimmtes Verfahren geschätzt wird, und der gemessenen Batterietemperatur umfassen, und
die Server-Steuereinheit (250)
• basierend auf einer ersten Bedingung, die Umweltdaten enthält, die Umweltdaten zum Diagnosezeitpunkt innerhalb eines vorbestimmten Bereichs entsprechen, und einer zweiten Bedingung, bei der es sich um einen vorherigen Diagnosezeitpunkt handelt, der der Anzahl von Proben basierend auf dem Diagnosezeitpunkt entspricht, die Vielzahl von Diagnosezeitpunkten extrahiert.

5. Server nach Anspruch 4, wobei:
die erste Bedingung
eine Bedingung ist, bei der eine Batterietemperatur zu einem vorbestimmten Diagnosezeitpunkt zu einem vorbestimmten Temperaturabschnitt, zu dem die dem Diagnosezeitpunkt entsprechende Batterietemperatur gehört, aus einer Vielzahl von Temperaturabschnitten gehört, die in vorbestimmten Temperaturgrößenintervallen eingestellt sind.

6. Server nach Anspruch 4, wobei:
die erste Bedingung
eine Bedingung ist, bei der ein SOC zu einem vorbestimmten Diagnosezeitpunkt zu einem vorbestimmten SOC-Abschnitt, zu dem der dem Diagnosezeitpunkt entsprechende SOC gehört, aus einer Vielzahl von SOC-Abschnitten gehört, die in vorbestimmten SOC-Größenintervallen eingestellt sind.

7. Verfahren zur Diagnose einer Batterie, wobei das Verfahren Folgendes umfasst:
• einen Datenempfangsvorgang (S100) zum Empfangen, durch einen Server, von Batteriedaten, die mindestens eines aus einer Batteriespannung, bei der es sich um eine Spannung an beiden Enden einer Batterie (10) handelt, einem Batteriestrom, bei dem es sich um einen durch die Batterie (10) fließenden Strom handelt, und einer Batterietemperatur, bei der es sich um eine Temperatur der Batterie (10) handelt, umfassen, von einem Batteriemanagementsystem, BMS, (40);
• einen Probengruppen-Bestimmungsvorgang (S200) zum Extrahieren, zu einem Diagnosezeitpunkt zur Diagnose eines Fehlers der Batterie (10), einer Vielzahl von vorherigen Diagnosezeitpunkten, die der vorbestimmten Anzahl von Proben basierend auf dem Diagnosezeitpunkt entsprechen;
• einen Referenzwert-Bestimmungsvorgang (S300) zum Berechnen eines gleitenden Mittelwerts (MA), der ein Mittelwert einer Vielzahl von internen Widerstandswerten (DCIR) ist, die jeweils der Vielzahl von Diagnosezeitpunkten entsprechen, eines oberen Bandschwellenwerts (UB_Th), der um einen vorbestimmten Wert größer als der gleitende Mittelwert (MA) ist, und eines unteren Bandschwellenwerts (LB_Th), der um einen vorbestimmten Wert kleiner als der gleitende Mittelwert (MA) ist; und
• einen Fehlerdiagnosevorgang (S400) zur Diagnose eines Fehlers in der Batterie durch Vergleichen des dem Diagnosezeitpunkt entsprechenden internen Widerstandswerts (DCIT) mit dem oberen Bandschwellenwert (UB_Th) und dem unteren Bandschwellenwert (LB_Th);
**dadurch gekennzeichnet, dass**:
der Referenzwert-Bestimmungsvorgang (S300) Folgendes enthält
• Berechnen (S320) eines Fehlerwerts (E) durch Multiplizieren eines Standardabweichungsmittelwerts, der ein Mittelwert einer Vielzahl von Standardabweichungen ist, die jeweils der Vielzahl von Diagnosezeitpunkten entsprechen, mit einem vorbestimmten Vielfachen,
• Berechnen (S330) des oberen Bandschwellenwerts (UB_Th) durch Addieren des Fehlerwerts (E) zum gleitenden Mittelwert (MA), und
• Berechnen (S330) des unteren Bandschwellenwerts (LB_Th) durch Subtrahieren des Fehlerwerts (E) vom gleitenden Mittelwert (MA).

8. Verfahren nach Anspruch 7, wobei:
im Fehlerdiagnosevorgang (S400),
wenn der dem Diagnosezeitpunkt entsprechende interne Widerstandswert (DCIR) den oberen Bandschwellenwert (UB_Th) überschreitet,
diagnostiziert wird, dass ein Trennungsfehler in mindestens einem einer Vielzahl von in der Batterie (10) enthaltenen Batteriezellen aufgetreten ist.

9. Verfahren nach Anspruch 7, wobei:
im Fehlerdiagnosevorgang (S400),
wenn der dem Diagnosezeitpunkt entsprechende interne Widerstandswert (DCIR) kleiner als der untere Bandschwellenwert (LB_Th) ist,
diagnostiziert wird, dass ein Kurzschlussfehler in mindestens einem einer Vielzahl von in der Batterie (10) enthaltenen Batteriezellen aufgetreten ist.

10. Verfahren nach Anspruch 7, wobei:
der Probengruppen-Bestimmungsvorgang (S200) Folgendes enthält
• Extrahieren der Vielzahl von Diagnosezeitpunkten basierend auf einer ersten Bedingung, die Umweltdaten umfasst, die Umweltdaten zum Diagnosezeitpunkt innerhalb eines vorbestimmten Bereichs entsprechen, und einer zweiten Bedingung, bei der es sich um einen vorherigen Diagnosezeitpunkt handelt, der der Anzahl von Proben basierend auf dem Diagnosezeitpunkt entspricht, und
die Umweltdaten Folgendes enthalten
• mindestens eines aus einem Ladezustand (SOC), der durch ein vorbestimmtes Verfahren geschätzt wird, und der gemessenen Batterietemperatur.

11. Verfahren nach Anspruch 10, wobei:
die erste Bedingung
eine Bedingung ist, bei der eine Batterietemperatur zu einem vorbestimmten Diagnosezeitpunkt zu einem vorbestimmten Temperaturabschnitt, zu dem die dem Diagnosezeitpunkt entsprechende Batterietemperatur gehört, aus einer Vielzahl von Temperaturabschnitten gehört, die in vorbestimmten Temperaturgrößenintervallen eingestellt sind.

12. Verfahren nach Anspruch 10, wobei:
die erste Bedingung
eine Bedingung ist, bei der ein SOC zu einem vorbestimmten Diagnosezeitpunkt zu einem vorbestimmten SOC-Abschnitt, zu dem der dem Diagnosezeitpunkt entsprechende SOC gehört, aus einer Vielzahl von SOC-Abschnitten gehört, die in vorbestimmten SOC-Größenintervallen eingestellt sind.

## Revendications

1. Un serveur (200) pour diagnostiquer un défaut dans une batterie (10), le serveur (200) comprenant :
une unité de communication de serveur (210) pour recevoir des données de batterie comprenant au moins l'un parmi une tension de batterie, qui est une tension aux deux bornes d'une batterie (10), un courant de batterie, qui est un courant circulant à travers la batterie (10), et une température de batterie, qui est une température de la batterie (10), en provenance d'un système de gestion de batterie, BMS, (40) ;
une unité de stockage de serveur (230) pour stocker une valeur de résistance interne (DCIR) de la batterie (10) calculée sur la base des données de batterie à chaque instant de diagnostic pour diagnostiquer un défaut dans la batterie (10) ; et
une unité de commande de serveur (250) pour extraire une pluralité d'instants de diagnostic précédents correspondant à un nombre prédéterminé d'échantillons sur la base de l'instant de diagnostic pour chaque instant de diagnostic, calculer une moyenne glissante (MA) qui est une moyenne d'une pluralité de valeurs de résistance interne (DCIR) correspondant respectivement à la pluralité d'instants de diagnostic, et comparer la valeur de résistance interne (DCIR) avec un seuil de bande supérieur (UB_Th), qui est supérieur à la moyenne glissante (MA) d'une valeur prédéterminée, et un seuil de bande inférieur (LB_Th), qui est inférieur à la moyenne glissante (MA) d'une valeur prédéterminée, pour diagnostiquer un défaut dans la batterie (10) ;
**caractérisé en ce que** :
l'unité de commande de serveur (250)
calcule une valeur d'erreur (E) en multipliant une valeur moyenne d'écart type, qui est une moyenne d'une pluralité d'écarts types correspondant respectivement à la pluralité d'instants de diagnostic, par un multiple prédéterminé,
calcule le seuil de bande supérieur (UB_Th) en ajoutant la valeur d'erreur (E) à la moyenne glissante (MA), et
calcule le seuil de bande inférieur (LB_Th) en soustrayant la valeur d'erreur (E) de la moyenne glissante (MA).

2. Le serveur selon la revendication 1, dans lequel :
lorsque la valeur de résistance interne (DCIR) dépasse le seuil de bande supérieur (UB_Th),
l'unité de commande de serveur (250) diagnostique qu'un défaut de déconnexion s'est produit dans au moins l'un d'une pluralité de cellules de batterie incluse dans la batterie (10).

3. Le serveur selon la revendication 1, dans lequel :
lorsque la valeur de résistance interne (DCIR) est inférieure au seuil de bande inférieur (LB_Th),
l'unité de commande de serveur (250) diagnostique qu'un défaut de court-circuit s'est produit dans au moins l'un d'une pluralité de cellules de batterie incluse dans la batterie (10).

4. Le serveur selon la revendication 1, dans lequel :
l'unité de stockage de serveur (230)
stocke en outre des données environnementales comprenant au moins l'un parmi un état de charge (SOC) estimé par une méthode prédéterminée et la température de batterie mesurée, et
l'unité de commande de serveur (250)
extrait la pluralité d'instants de diagnostic sur la base d'une première condition comprenant des données environnementales correspondant à des données environnementales à l'instant de diagnostic dans une plage prédéterminée et d'une seconde condition, qui est un instant de diagnostic précédent correspondant au nombre d'échantillons sur la base de l'instant de diagnostic.

5. Le serveur selon la revendication 4, dans lequel :
la première condition
est une condition dans laquelle une température de batterie à un instant de diagnostic prédéterminé appartient à une section de température prédéterminée à laquelle appartient la température de batterie correspondant à l'instant de diagnostic parmi une pluralité de sections de température définies à des intervalles de taille de température prédéterminés.

6. Le serveur selon la revendication 4, dans lequel :
la première condition
est une condition dans laquelle un SOC à un instant de diagnostic prédéterminé appartient à une section de SOC prédéterminée à laquelle appartient le SOC correspondant à l'instant de diagnostic parmi une pluralité de sections de SOC définies à des intervalles de taille de SOC prédéterminés.

7. Un procédé de diagnostic d'une batterie, le procédé comprenant :
une opération de réception de données (S100) pour recevoir, par un serveur, des données de batterie comprenant au moins l'une parmi une tension de batterie, qui est une tension aux deux bornes d'une batterie (10), un courant de batterie, qui est un courant circulant à travers la batterie (10), et une température de batterie, qui est une température de la batterie (10), en provenance d'un système de gestion de batterie, BMS, (40) ;
une opération de détermination de groupe d'échantillons (S200) pour extraire, à un instant de diagnostic pour diagnostiquer un défaut de la batterie (10), une pluralité d'instants de diagnostic précédents correspondant au nombre prédéterminé d'échantillons sur la base de l'instant de diagnostic ;
une opération de détermination de valeur de référence (S300) consistant à calculer une moyenne glissante (MA), qui est une moyenne d'une pluralité de valeurs de résistance interne (DCIR) correspondant respectivement à la pluralité d'instants de diagnostic, un seuil de bande supérieur (UB_Th), supérieur à la moyenne glissante (MA) d'une valeur prédéterminée, et un seuil de bande inférieur (LB_Th), inférieur à la moyenne glissante (MA) d'une valeur prédéterminée ; et
une opération de diagnostic de défaut (S400) consistant à diagnostiquer un défaut dans la batterie en comparant la valeur de résistance interne (DCIT) correspondant à l'instant de diagnostic avec le seuil de bande supérieur (UB_Th) et le seuil de bande inférieur (LB_Th) ;
**caractérisé en ce que** :
l'opération de détermination de valeur de référence (S300) comprend
calculer (S320) une valeur d'erreur (E) en multipliant une valeur moyenne d'écart type, qui est une moyenne d'une pluralité d'écarts types correspondant respectivement à la pluralité d'instants de diagnostic, par un multiple prédéterminé,
calculer (S330) un seuil de bande supérieur (UB_Th) en ajoutant la valeur d'erreur (E) à la moyenne glissante (MA), et
calculer (S330) un seuil de bande inférieur (LB_Th) en soustrayant la valeur d'erreur (E) de la moyenne glissante (MA).

8. Le procédé selon la revendication 7, dans lequel :
dans l'opération de diagnostic de défaut (S400),
lorsque la valeur de résistance interne (DCIR) correspondant à l'instant de diagnostic dépasse le seuil de bande supérieur (UB_Th),
il est diagnostiqué qu'un défaut de déconnexion s'est produit dans au moins l'un d'une pluralité de cellules de batterie incluse dans la batterie (10).

9. Le procédé selon la revendication 7, dans lequel :
dans l'opération de diagnostic de défaut (S400),
lorsque la valeur de résistance interne (DCIR) correspondant à l'instant de diagnostic est inférieure au seuil de bande inférieur (LB_Th),
il est diagnostiqué qu'un défaut de court-circuit s'est produit dans au moins l'un d'une pluralité de cellules de batterie incluse dans la batterie (10).

10. Le procédé selon la revendication 7, dans lequel :
l'opération de détermination de groupe d'échantillons (S200) comprend
extraire la pluralité d'instants de diagnostic sur la base d'une première condition comprenant des données environnementales correspondant à des données environnementales à l'instant de diagnostic dans une plage prédéterminée et d'une seconde condition, qui est un instant de diagnostic précédent correspondant au nombre d'échantillons sur la base de l'instant de diagnostic, et
les données environnementales comprennent
au moins l'un parmi un état de charge (SOC) estimé par une méthode prédéterminée et la température de batterie mesurée.

11. Le procédé selon la revendication 10, dans lequel :
la première condition
est une condition dans laquelle une température de batterie à un instant de diagnostic prédéterminé appartient à une section de température prédéterminée à laquelle appartient la température de batterie correspondant à l'instant de diagnostic parmi une pluralité de sections de température définies à des intervalles de taille de température prédéterminés.

12. Le procédé selon la revendication 10, dans lequel :
la première condition
est une condition dans laquelle un SOC à un instant de diagnostic prédéterminé appartient à une section de SOC prédéterminée à laquelle appartient le SOC correspondant à l'instant de diagnostic parmi une pluralité de sections de SOC définies à des intervalles de taille de SOC prédéterminés.
